# DEMANDE DE BREVET EUROPEEN

(11) **EP 0 577 518 A1**
(43) Date de publication de la demande: **05.01.1994**
(21) Numéro de dépôt: 93401715.3
(22) Date de dépôt: 01.07.1993
(51) Int. Cl.: H03L 7/097, H03L 7/18

(54) **Dispositif de synchronisation d'une machine et imprimante à jet d'encre utilisant un tel dispositif**

(30) Priorité: 01.07.1992 FR 9208111
(71) Demandeur: IMAJE, F-26500 Bourg les Valence (FR)
(72) Inventeur: Prevoteau, Thierry, Cabinet Ballot-Schmit, F-75116 Paris (FR)
(74) Mandataire: Dubois-Chabert, Guy

(57) **Abrégé**

L'invention concerne un dispositif électronique de synchronisation du fonctionnement d'une machine au déplacement du produit sur lequel elle doit intervenir, comprenant un générateur (5) d'un signal impulsionnel représentatif du déplacement du produit, associé à un détecteur de reconnaissance (7) du produit, qui sont connectés à un circuit de commande (57) du fonctionnement de la machine (1), caractérisé en ce qu'il comprend de plus un multiplicateur de fréquence (9) par un nombre rationnel, placé entre le générateur et le circuit de commande de la machine, multipliant la fréquence du signal issu du générateur dans un rapport de multiplication déterminé en fonction des variations temporelles de vitesse du produit et du nombre d'impulsions du signal issu du générateur.

Elle concerne également l'utilisation d'un tel dispositif de synchronisation dans une imprimante à jet d'encre.

## Description

L'invention concerne un dispositif électronique de synchronisation du fonctionnement d'une machine au déplacement du produit sur lequel elle doit intervenir. Elle concerne également l'utilisation d'un tel dispositif de synchronisation dans une imprimante à jet d'encre.

Actuellement un dispositif de synchronisation du fonctionnement d'une machine au déplacement du produit sur lequel elle intervient, comporte un générateur d'impulsions délivrant un signal représentatif du déplacement du produit, associé à un détecteur de reconnaissance du produit pour déclencher l'intervention de la machine sur le produit. Un premier problème se pose pour ajuster la distance entre le lieu de détection du produit et le lieu d'intervention de la machine sur le produit, soit par réglage manuel soit par emploi d'appareils coûteux et encombrants. Un second problème provient du retard entre la détection du produit et sa prise en compte pour déclencher la machine, problème difficilement maîtrisable sans augmentation du coût de l'installation.

Le but de l'invention est de résoudre de façon simple et fiable les inconvénients précités, en proposant un dispositif de synchronisation utilisant la multiplication d'une fréquence temporelle résultant d'une fréquence spatiale.

Pour cela, un des objets de l'invention est un dispositif de synchronisation du fonctionnement d'une machine au déplacement du produit sur lequel elle intervient, comprenant un dispositif générateur d'un signal impulsionnel représentatif du déplacement du produit, associé à un détecteur de reconnaissance du produit, ledit générateur et ledit détecteur étant connectés à un circuit de commande du fonctionnement de la machine, caractérisé en ce qu'il comprend de plus un multiplicateur de fréquence par un nombre rationnel, placé entre le générateur et le circuit de commande de la machine, multipliant la fréquence du signal issu du générateur dans un rapport de multiplication déterminé en fonction des variations temporelles de vitesse du produit et du nombre d'impulsions du signal issu du générateur.

A propos des imprimantes à jet d'encre, composées soit de plusieurs modules d'impression accolés placés successivement dans le sens du déplacement du produit à imprimer, soit de plusieurs modules accolés perpendiculairement à la direction de déplacement, particulièrement adaptées à l'écriture de motifs variables, se posent des problèmes de précision des motifs dus au positionnement des modules entre eux. Un autre but de l'invention est de résoudre ces derniers problèmes en proposant une imprimante à jet d'encre utilisant un dispositif de synchronisation doté d'un multiplicateur de fréquence, particulièrement adaptée à l'écriture de motifs variables.

Le second objet de l'invention est une imprimante à jet d'encre continu dévié, constituée d'au moins deux têtes d'impression accolées, placées parallèlement à la direction et dans le sens de déplacement du produit à imprimer, chaque tête écrivant une succession de repères régulièrement espacés à fréquence fixe, corrélativement à l'impression du motif, caractérisée en ce que chaque tête d'impression est synchronisée sur le déplacement du produit à l'aide d'un dispositif de synchronisation elon l'invention, le dispositif de synchronisation de la première tête d'impression comprenant un générateur d'impulsions relié à un multiplicateur de fréquence envoyant un signal de déclenchement au circuit de commande des jets de ladite tête et le dispositif de synchronisation de la seconde tête d'impression comprenant un photodétecteur, détectant les repères émis par la première tête sur le produit et relié à un multiplicateur de fréquence et au circuit de commande des jets de ladite seconde tête.

Un autre objet de l'invention est une imprimante à jet d'encre continu dévié constituée d'au moins deux modules d'impression accolés perpendiculairement à la direction de déplacement du produit à imprimer et imprimant respectivement deux trames d'encre, caractérisée en ce que chaque module est synchronisé sur le fonctionnement de l'autre module à l'aide d'un dispositif de synchronisation selon l'invention, comprenant un dispositif délivrant un signal Ng représentatif du déplacement du produit à imprimer, relié à un multiplicateur de fréquence, lui-même connecté au circuit de commande des jets des deux modules.

D'autres caractéristiques et avantages de l'invention apparaîtront dans la description qui suit, illustrée par les figures 1 à 10, où:
- la figure 1 est un dispositif de synchronisation d'une machine, selon l'invention;
- la figure 2 est un chronogramme des signaux émis par les différents éléments du dispositif de synchronisation, selon l'invention;
- la figure 3 est un schéma d'un exemple particulier de dispositif multiplicateur de fréquence d'un signal périodique;
- la figure 4 est un chronogramme des signaux en sortie des éléments constitutifs dudit multiplicateur;
- la figure 5 est un schéma d'une imprimante à jet d'encre, selon l'invention;
- la figure 6 est un schéma électronique d'un dispositif de synchronisation d'une imprimante à jet d'encre, selon la figure 5;
- la figure 7 est un chronogramme des signaux en sortie du dispositif de synchronisation de l'imprimante, selon la figure 5;
- la figure 8 est un schéma d'une imprimante multijet selon l'invention;
- la figure 9 est un schéma électronique du dispositif de synchronisation de l'imprimante selon la figure 8;
- la figure 10 est un chronogramme des signaux en sortie du dispositif selon la figure 9.

Les éléments portant les mêmes références dans les différentes figures remplissent les mêmes fonctions en vue des mêmes résultats.

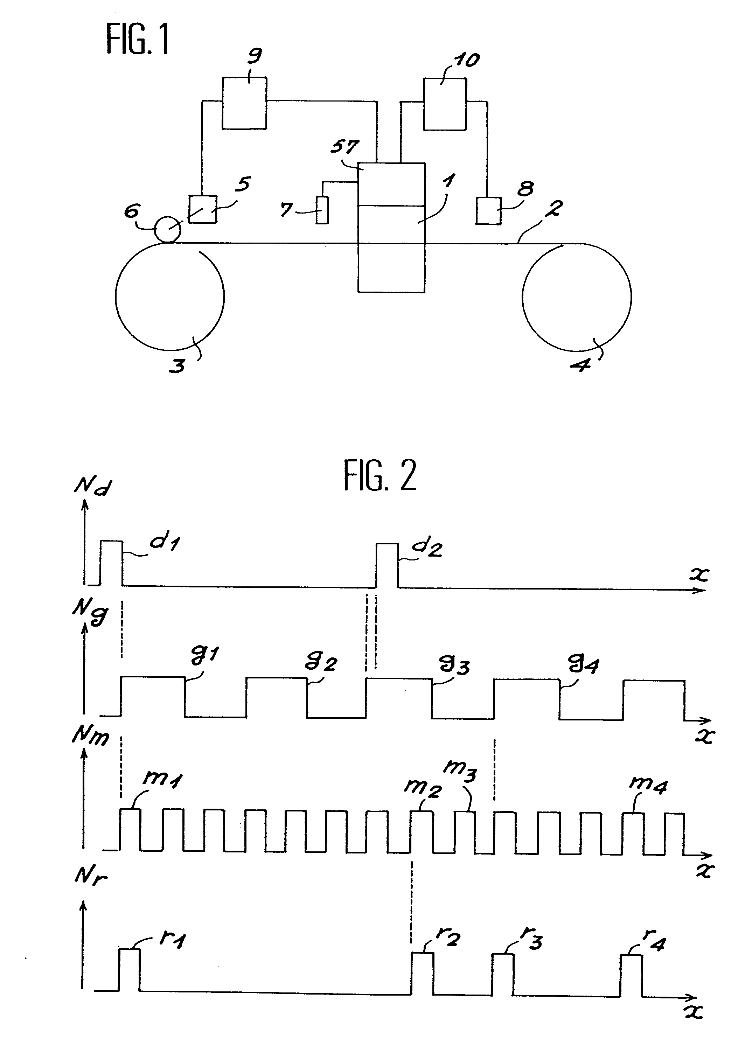

Un procédé de fabrication industrielle utilise couramment une machine 1 dont le rôle est d'intervenir sur un produit, pour lui apporter une valeur ajoutée, ce produit défilant continûment dans la machine. Sur la figure 1, la machine 1 doit agir sur un produit placé sur un support 2 défilant dans la machine et entraîné par des éléments 3 et 4, dont la vitesse et le couple d'entraînement peuvent être contrôlés. Le support 2 peut être le convoyeur du produit à modifier par la machine, ou le produit lui-même - une bande de papier, de tissu ou de polychlorure de vinyle (PVC) sur lequel on dépose un autre produit- ou bien encore un tube issu d'un autre procédé sur lequel on désire imprimer des motifs. Actuellement, pour synchroniser le fonctionnement de la machine 1 au déplacement du support 2, on utilise un dispositif délivrant un signal représentatif du déplacement du support 2 et un détecteur 7 reconnaissant les objets disposés sur ledit support ou des repères portés directement sur ce dernier. Ledit dispositif peut être constitué soit d'un tachymètre ou d'un générateur d'impulsions 5 en contact mécanique avec le support 2 par l'intermédiaire d'une roue 6 par exemple, soit d'un photodétecteur 8. Le détecteur 7 peut être un fin de course, un détecteur de proximité, une cellule photoélectrique ou autre. Les signaux issus à la fois du générateur 5 et du détecteur 7 sont envoyés à un circuit de commande 57 du fonctionnement de la machine qui autorise le déclenchement de celle-ci pour qu'elle agisse sur le produit à modifier, selon la procédure suivante explicitée par le chronogramme de la figure 2. Le signal N_{d} étant issu du détecteur 7, les impulsions d₁ et d₂ correspondent aux instants de reconnaissance des produits; le signal N_{g} étant issu du générateur d'impulsions 5 , les impulsions g₁ à g₄ sont représentatives du déplacement des produits disposés sur le support 2 par rapport à la machine 1 et le signal Nᵣ, résultant de la combinaison des signaux N_{d} et Ng dans le circuit de commande 57, est destiné à déclencher le fonctionnement de la machine 1. Après détection du produit lors de l'impulsion d₁, est élaborée sur le premier front montant de l'impulsion g₁ du signal Ng qui lui succède immédiatement, une impulsion r₁ du signal Nᵣ déclenchant le fonctionnement de la machine 1, soit instantanément soit après temporisation d'un certain nombre d'impulsions du signal Ng tenant compte d'un éventuel déplacement entre la reconnaissance du produit par le détecteur 7 et le lieu d'application de l'intervention de la machine sur ledit produit. Selon ce nombre d'impulsions du signal N_{g} par unité de défilement du produit, deux problèmes se posent. Tout d'abord, si la distance entre le lieu de détection du produit, repéré par l'impulsion d₁, et le lieu d'action de la machine sur le produit ne correspond pas à un nombre entier d'impulsions du signal N_{g}, il est nécessaire actuellement d'ajuster cette distance en réglant manuellement la position du détecteur 7, ce qui est une opération délicate. Une autre solution consiste à augmenter le nombre d'impulsions délivrées par le générateur 5, ce qui présente l'inconvénient d'utiliser des appareils coûteux et encombrants.

Le second problème qui peut se poser vient du caractère aléatoire de l'apparition des impulsions du signal Nd, traduisant la reconnaissance du produit sur le support 2, vis à vis des impulsions du signal périodique N_{g}, traduisant le défilement dudit support. Dans le cas de l'impulsion d₁ du signal N_{d} qui se présente avant le front montant d'une impulsion g₁ du signal Ng, le signal résultant Nᵣ se traduit par une impulsion r₁ permettant le déclenchement de la machine. Par contre, dans le cas de l'impulsion d₁ du signal Nd se présentant peu de temps après le dernier front montant de l'impulsion g₃ du signal Ng, l'impulsion r₃ du signal résultant Nᵣ n'apparaîtra que lors du front montant de l'impulsion suivante g₄ du signal Ng, donc après un certain retard. Les causes de ce retard étant multiples, le problème ne peut être maîtrisé sans augmenter le coût de l'installation. Or ce problème doit être résolu aussi bien pour une machine intervenant sur une suite discrète d'objets que pour un procédé continu où les interventions de la machine sont déclenchées sur les fronts montants du signal N_{g} de défilement, sans l'utilisation d'un détecteur 7. Dans ce dernier cas, le nombre d'impulsions du signal N_{g} doit être au moins égal au nombre d'interventions souhaitées. La génération des impulsions du signal Ng peut être réalisée par le générateur 5 associé à un dispositif mécanique 6 en contact avec le mécanisme d'entraînement 3 du produit ou avec le produit lui-même, par exemple une roue dont la développée est représentative du déplacement du produit. Lorsque le produit constitue lui-même un élément continu tel qu'une bande, une poutre ou un tube, les impulsions du signal N_{g} peuvent résulter de repères directement disposés sur le produit, lus par un système optique simple comme le photodétecteur 8, mais là encore la précision sur le déplacement du produit est fonction du nombre de repères sur le produit.

La présente invention résout ces problèmes en proposant un dispositif de synchronisation d'une machine 1 au déplacement du produit sur lequel elle doit intervenir comportant un générateur d'impulsions 5 associé à un dispositif mécanique 6 en contact avec le mécanisme d'entraînement 3 du produit, un dispositif multiplicateur de fréquence 9, placé entre le générateur 5 et le circuit de commande 57 du fonctionnement de la machine 1, et un détecteur 7. Dans le cas d'un dispositif de synchronisation avec photo-détecteur 8, le multiplicateur, référencé 10, est placé entre ledit photo-détecteur et le circuit de commande 57 de la machine.

Le multiplicateur 9, respectivement 10, reçoit en entrée le signal N_{g} issu du générateur 5, respectivement du photo-détecteur 8, et délivre à la machine 1 un signal Nm périodique impulsionnel dont la fréquence est un multiple de la fréquence du signal N_{g}. En augmentant ainsi la fréquence spatiale, on augmente la précision sur le déplacement du produit mesuré à son passage dans la machine. La fiabilité du dispositif de synchronisation sera d'autant plus grande que les variations de vitesse du déplacement du produit seront faibles en regard des vitesses de déplacement des repères physiques générant le signal Ng. En effet, le rapport de la fréquence temporelle à la fréquence spatiale est homogène à une vitesse. Si la précision spatiale sur le déplacement du produit doit être l'image de la distance qui sépare deux impulsions successives m₂ et m₃ du signal Nₘ, il faut et il suffit que, pour le signal Nm, le nombre d'impulsions existant entre les impulsions générées à partir de l'impulsion g₃ du signal Ng et les impulsions générées à partir de l'impulsion g₄ ne diffère pas de plus d'une impulsion. Le rapport de multiplication du multiplicateur 9 ou 10 est alors déterminé en fonction des variations temporelles de vitesse du produit et du nombre d'impulsions du signal N_{g} issues du générateur 5. Lorsque le fonctionnement de la machine doit être déclenché en tenant compte du déplacement du produit, chaque impulsion du signal Nr de déclenchement, par exemple l'impulsion r₄, doit être élaborée à partir d'une impulsion du signal N_{d}, d₁ par exemple, et d'un certain nombre d'impulsions du signal N_{g} ou Nm séparant cette impulsion dl de l'impulsion r₄, ce nombre d'impulsions étant représentatif du déplacement du produit.

Si on utilise directement le signal N_{g} issu du générateur 5, ou du photo-détecteur 8, comme dans l'art antérieur, le retard entre l'impulsion d₁ et l'impulsion de déclenchement du signal Nᵣ ne peut correspondre qu'à un nombre entier d'intervalles séparant deux impulsions successives du signal Ng. Dans le cas d'une détection du produit correspondant à l'impulsion d₂ du signal Nd, arrivant immédiatement après le front montant de l'impulsion g₃ du signal N_{g}, la machine sera déclenchée par l'impulsion r₃, lors du front montant de l'impulsion g4 succédant à l'impulsion g3 du signal Ng. Le retard entre les impulsions d₂ et r₃ peut atteindre le temps séparant les deux fronts montants de deux impulsions successives, g₃ et g₄, du signal Ng.

En utilisant un multiplicateur de fréquence 9 ou 10 délivrant un signal Nm, le retard entre l'impulsion d₁ et l'impulsion de déclenchement du signal Nᵣ peut correspondre à une fraction quelconque de la somme des intervalles séparant deux impulsions successives du signal Ng issu du générateur 5 ou du photo-détecteur 8, permettant ainsi un ajustement plus précis. Dans ce cas, le déclenchement de la machine se fera par l'impulsion r₂ du signal Nᵣ, lors du front montant de l'impulsion m₂ du signal Nₘ apparaissant juste après l'impulsion d₂. La machine sera donc déclenchée plus tôt avec un dispositif de synchronisation selon l'invention. Le circuit multiplicateur 9 ou 10 permet de multiplier la fréquence du signal N_{g} issu du générateur ou du photo-détecteur par un nombre rationnel Q₁ quelconque en utilisant un circuit multipliant la fréquence par un nombre entier N et en divisant le résultat obtenu par un second nombre entier M, cette division étant réalisée par un compteur numérique classique.

Le multiplicateur 9 ou 10 peut être un multiplicateur de type analogique, par exemple, à l'entrée duquel deux signaux de fréquences respectives F₁ et F₂ sont appliqués, et qui délivre en sortie une raie de fréquence F₀ = F₁+F₂. La raie de fréquence F₀ est ensuite filtrée, puis le signal est amplifié et remis en forme. Dans le cas d'une multiplication de la fréquence F₀ par un nombre entier N, il faut donc mettre plusieurs multiplicateurs en cascade, avec une mise à niveau en entrée et en sortie pour chaque étage.

Ainsi, un multiplicateur de fréquence analogique comprend un filtre passe-bande accordé sur la fréquence F₀*N, un amplificateur de remise en forme et, dans certains cas, des moyens de remise en phase du signal de fréquence F₀*N pour compenser le retard introduit par le filtrage. Comme cela a été dit auparavant, ce type de multiplicateur est spécifique de chaque fréquence incidente et nécessite un filtrage étroit, aux basses fréquences, pour séparer les raies de fréquences différentes, augmentant alors le retard à compenser.

Le multiplicateur de fréquence 9 ou 10 peut aussi être à boucle de verrouillage de phase, dans lequel c'est un oscillateur commandé en tension qui délivre un signal de fréquence F₀*N, multiple de la fréquence F₀ du signal d'entrée. Ce signal de fréquence N*F₀ est ensuite divisé par N, puis une comparaison de phase est faite entre le signal incident de fréquence F₀ et le signal de fréquence de fréquence F₀ résultant de la division par N du signal délivré par l'oscillateur commandé en tension. Après filtrage des fréquences harmoniques supérieures, la tension d'erreur résultant de cette comparaison de phases permet de verrouiller l'oscillateur sur la fréquence F₀*N, en fréquence et en phase.

Un tel multiplicateur de fréquence à boucle de verrouillage de phase est plus performant qu'un multiplicateur analogique et a pour particularité que sa plage d'accrochage et de poursuite sur la fréquence du signal d'entrée est liée au facteur K₀ de l'oscillateur, facteur qui représente l'excursion de fréquence couverte par une unité de la tension de commande appliquée à l'oscillateur. Pour un oscillateur à quartz, ce facteur K₀ est de l'ordre de 10⁻³ à 10⁻⁴, de sorte que l'excursion de fréquence est faible et que pour chaque fréquence d'entrée que l'on veut multiplier, il faut utiliser un multiplicateur spécifique. Avec un oscillateur classique, la gamme de fréquence peut varier dans un rapport de 4 entre les fréquences extrêmes à l'entrée. En sortie du comparateur de phase, il est nécessaire de filtrer en passe-bas pour obtenir la tension de commande du V.C.O. Pour couvrir des plages lus importantes, il faut utiliser des montages plus complexes nécessitent des commutations de gammes. De plus un tel multiplicateur ne convient pas pour de très basses fréquences d'entrée.

Le multiplicateur 9 ou 10 peut également être un multiplicateur d'un type particulier, multipliant la fréquence d'un signal périodique, de type logique, par un nombre rationnel sur une large bande de fréquence, de conception simple, nécessitant des moyens moins nombreux, moins coûteux et plus simples à mettre en oeuvre que les multiplicateurs précédents.

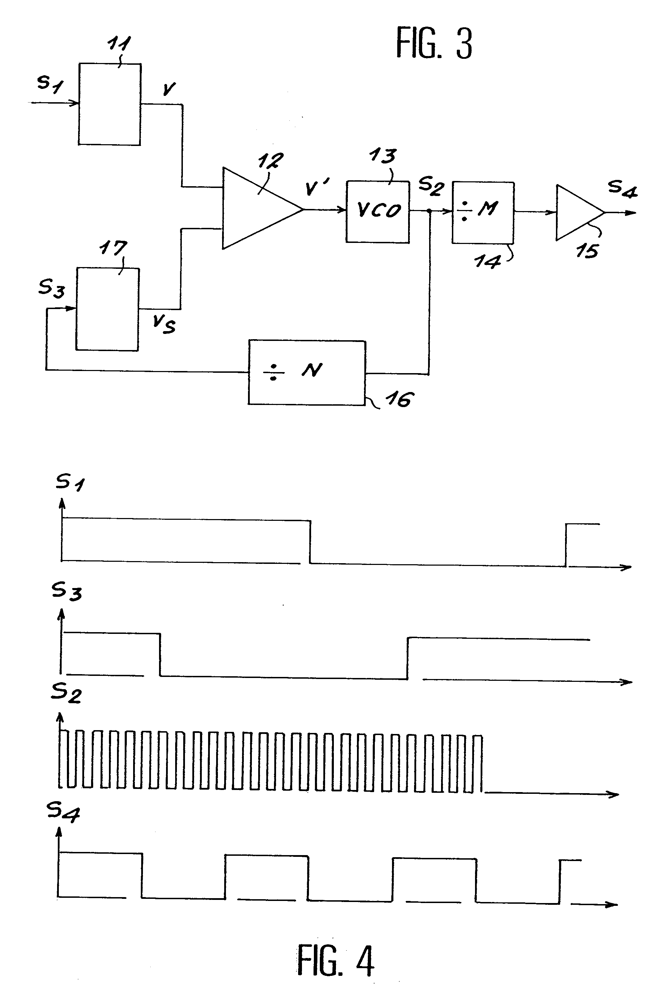

Sur la figure 3 est représenté schématiquement un tel dispositif multiplicateur, qui comprend un convertisseur fréquence-tension 11, à l'entrée duquel est appliqué le signal d'entrée S₁ de fréquence F et qui délivre en sortie une tension V qui est une fonction linéaire de la fréquence d'entrée F. Cette tension V de sortie est égale à F*K, où K est une constante définie par le convertisseur. Pour une fréquence d'entrée F variant de 0 à 50 KHz, par exemple, le convertisseur fréquence-tension 11 délivre en sortie une tension V de 0 à 10 Volts.

La sortie du convertisseur 11 attaque une entrée d'un amplificateur d'erreur 12 dont le signal de sortie, qui est une tension V', commande un oscillateur contrôlé en tension (V.C.O.) 13, dont le rôle est celui d'un convertisseur tension-fréquence. La sortie de l'oscillateur 13 délivre un signal carré périodique S₂, de fréquence F', qui est proportionnelle à la tension d'entrée V'. Ce signal carré attaque un compteur 14 monté en circuit diviseur de fréquence par un nombre entier M, dont la sortie est reliée à un amplificateur 15 qui délivre un signal représentant le signal de sortie S₄ du dispositif multiplicateur de fréquence Fₛ. Afin d'assurer une parfaite linéarité et stabilité du dispositif, il faut asservir le montage et pour cela, le signal de sortie S₂ de l'oscillateur 13, de fréquence F', est renvoyé sur la seconde entrée de l'amplificateur d'erreur 12. Ce retour est effectué après passage par un compteur 16, monté en circuit diviseur par N pour permettre la programmation de la multiplication et par un convertisseur fréquence-tension 17 recevant le signal S₃ du diviseur 16, destiné à donner une image en tension Vₛ de la fréquence de sortie Fₛ du dispositif, avec Fₛ = F*(N/M). Le signal S₃ n'est pas nécessairement en phase avec le signal S₁ mais les signaux S₂, S₃ et S₄ sont toujours en phase.

Si la linéarité de l'oscillateur commandé en tension importe peu, par contre les deux convertisseurs fréquence-tension doivent avoir des caractéristiques, notamment le facteur K, rigoureusement identiques pour que le facteur de multiplication N programmé corresponde à la multiplication obtenue.

L'asservissement étant du type à synthèse de tension, le dispositif fonctionne sur une large bande de fréquence. La figure 4 est un chronogramme des signaux apparaissant sur les différents éléments du multiplicateur: S1 est le signal, de fréquence F, entrant dans le convertisseur fréquence-tension 11; S2 est le signal, de fréquence F'= F*N, avec N=30 dans ce cas de figure, issu de l'oscillateur 13; S3 est le signal à l'entrée du second convertisseur fréquence-tension 17, soit le signal S2 dont la fréquence est divisée par 30; et S4 est le signal de sortie du multiplicateur et dont la fréquence Fs = F*(N/M) = F*(30/10).

C'est pourquoi un tel multiplicateur de fréquence peut être avantageusement utilisé dans la réalisation d'un dispositif de synchronisation d'une machine.

Un dispositif de synchronisation tel qu'il vient d'être décrit peut être avantageusement utilisé pour le fonctionnement d'une imprimante à jet d'encre, qui est particulièrement adaptée à l'écriture de motifs variables. Le fonctionnement d'une telle imprimante est décrit dans le brevet français 2 576 251, où on apprend qu'un motif est réalisé sur un produit à l'aide d'une succession de trames contiguës ou disjointes, chaque trame se composant d'une succession de gouttelettes déviées à partir d'un jet brisé d'encre.

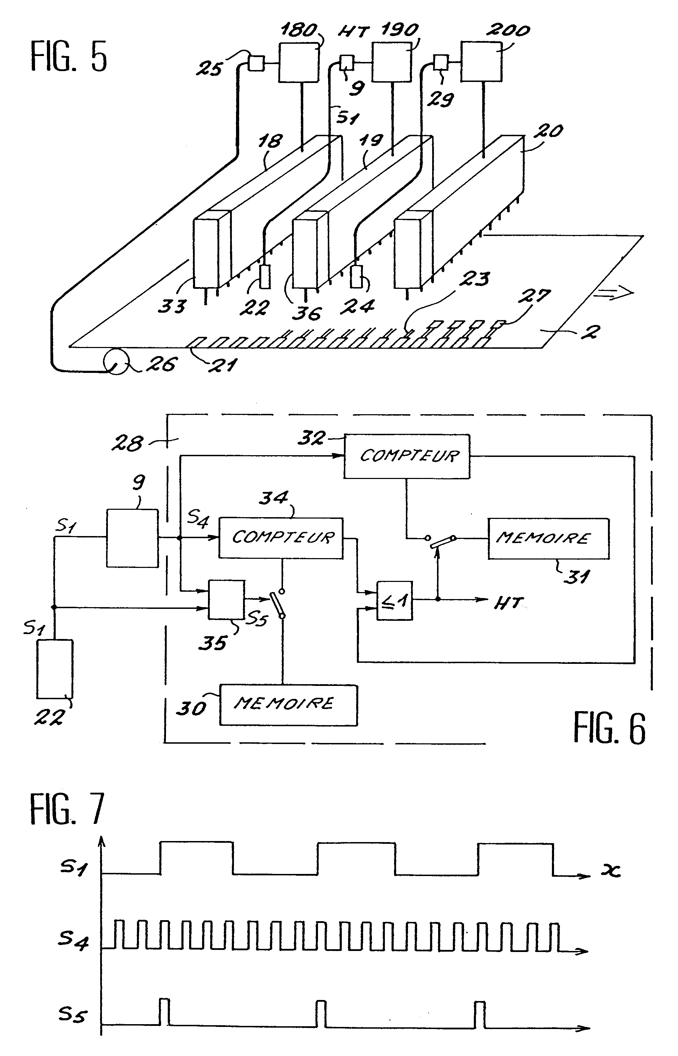

Dans le cas d'une imprimante à jet d'encre composée de plusieurs têtes d'impression 18, 19, 20 accolées, placées successivement dans la direction et suivant le sens de déplacement du produit 2 à imprimer, comme le montre la figure 5, par exemple trois têtes pour imprimer trois couleurs différentes, le problème à résoudre est celui de la parfaite superposition des couleurs. Actuellement, la première tête d'impression 18 écrit sur le bord du produit 2 une succession de repères 21 régulièrement espacés à fréquence fixe, corrélativement à l'impression du motif. La lecture de ces repères 21, par un capteur photoélectrique 22 par exemple, permet le déclenchement de l'impression par la seconde tête 19, qui imprime sur le produit simultanément les trames réalisant le second motif et une succession de repères 23 à une fréquence légèrement différente de la fréquence des repères 21. Ces deux suites de repères sont ensuite lues simultanément en sortie de la seconde tête d'impression, et le battement de fréquence obtenu est rebouclé en contre-réaction sur le signal d'entrée de la seconde tête qui est élaboré à partir de la première suite de repères imprimés par la première tête. Ainsi les trames imprimées par la seconde tête peuvent être décalées pour coïncider avec les trames imprimées par la première tête, au niveau des motifs. La même procédure est répétée pour les modules suivants. Mais la précision spatiale de chaque repère ne peut dépasser la valeur du diamètre d'une goutte d'encre, correspondant à la tranche d'une trame, de sorte que les trames constituant les motifs ne peuvent être positionnées avec une plus grande précision.

Grâce à l'invention, l'imprimante utilisant un dispositif de synchronisation du fonctionnement des têtes les unes par rapport aux autres peut générer un nombre d'impulsions supérieur au nombre de repères, dans un rapport rationnel quelconque, et de choisir électroniquement parmi ces impulsions lesquelles permettront le déclenchement de l'impression des trames. Comme le montre la figure 5, la première tête d'impression 18 est synchronisée sur le déplacement du support 2 à l'aide d'un dispositif de synchronisation selon l'invention comprenant un générateur d'impulsions 26 en contact mécanique avec le support 2 et un multiplicateur de fréquence 25. Les repères 21 émis par un module 33 placé à l'extrémité de la tête 18, sur commande du dispositif électronique 180 de commande des jets de la tête 18, permettent de synchroniser la génération des trains de gouttes émises par la tête 19 avec les trains de gouttes émis par la tête 18 indépendamment des modifications géométriques que pourrait subir le support 2 pendant son déplacement de la tête 18 à la tête 19, par dilatation par exemple due à une variation de température ou de traction. Cette synchronisation s'effectue à l'aide d'un photodétecteur 22 qui détecte les repères 21 du support 2 et transmet un signal impulsionnel S₁ simultanément à un multiplicateur de fréquence 9 et au dispositif électronique 190 de commande des jets de la tête 19, qui comprend notamment un système de traitement électronique 28, détaillé sur la figure 6. Ce système 28 est constitué par un circuit logique de déclenchement 35, qui à l'aide du signal S₄ fourni par le multiplicateur 9, génère un signal S₅ en phase avec le signal S₄ sur chaque front montant du signal S₁. Le chronogramme de ces signaux constitue la figure 7. Le signal S₅ charge sur interruption, dans un compteur 34, une valeur V1 inscrite dans une mémoire 30 par un opérateur, qui évalue la bonne superposition des motifs imprimés par les deux têtes 18 et 19. Cette valeur V1 correspond au nombre d'impulsions du signal S₄ qui sépare le front montant d'une impulsion du signal S₁ du premier déclenchement d'impression lié à cette impulsion. En effet le compteur 34 décompte les impulsions du signal S₄ de la valeur V₁ et élabore un signal d'interruption Z₃₄ sur passage à zéro du compteur. Ce signal Z₃₄ déclenche l'émission du premier train de gouttes par le signal Hₜ. Le signal Hₜ envoyé dans le dispositif électronique 190 de commande des jets de la tête 19, déclenche les trains de gouttes suivants liés à une même impulsion du Signal S₁ à partir de l'interruption Z₃₂, générée par le passage à zéro du compteur 32 dans lequel les impulsions S₄ viennent décompter une valeur V₂ chargée à partir d'une mémoire 31, simultanément à chaque signal de déclenchement Hₜ. La valeur V₂ correspond au nombre d'impulsions du signal S₄ qui sépare deux trames successives. Un dispositif de synchronisation identique au précédent, avec un multiplicateur de fréquence 29, commande la tête d'impression 20 à partir des signaux lus par un capteur photoélectrique 24. En même temps le module extrême 36 de la tête 19 imprime sur le support 2 des repères 23 qui se superposent à certains repères 21 imprimés par la première tête 18 car les repères 23 sont générés à une fréquence différente de celle des repères 21. Ainsi certains repères 21 ne seront pas recouverts, d'autres seront recouverts par des repères 23 ou 27, d'autres encore par des repères 23 et 27 à la fois, ce qui permet d'apprécier la bonne superposition des trames imprimées par les trois têtes sur le support 2, tout en s'y repérant.

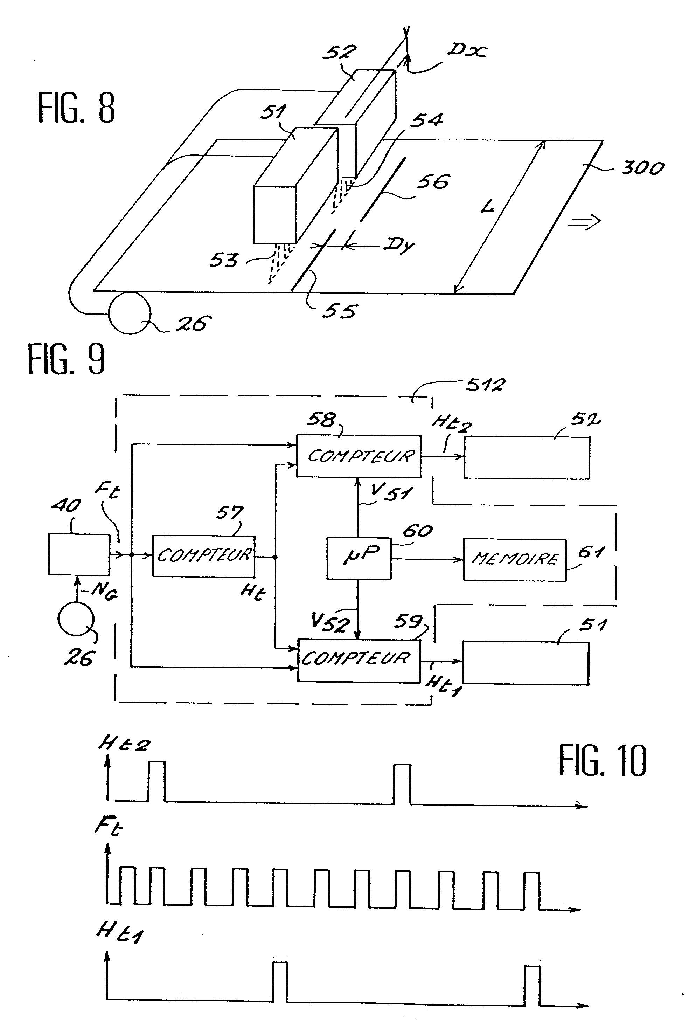

Lorsque l'on veut imprimer des motifs de grande largeur sur un produit, par exemple une bande de papier ou de tissu, on utilise une imprimante comportant plusieurs modules d'impression accolés suivant une même direction perpendiculaire à la direction de déplacement du produit sous l'imprimante. Il est bien entendu très difficile d'aligner parfaitement les modules, de sorte qu'un décalage se produit dans le raccordement des trames imprimées par les différents modules sur le produit. La figure 8 est un exemple de réalisation d'une imprimante à deux modules accolés 51 et 52, au-dessus d'un produit 300 de grande largeur L, se déplaçant suivant le sens de la flèche, perpendiculairement à la direction d'alignement supposée des deux modules. Les modules d'impression 51 et 52 projettent respectivement deux trains de gouttes d'encre 53 et 54. Les tolérances mécaniques du dispositif de montage des modules autorisent une erreur Dx dans l'alignement du module 52 en avance ou en retard par rapport au module 51; cette distance Dx est volontairement dilatée sur la figure 8. Actuellement, cette erreur d'alignement des modules entraîne un écart Dy dans la juxtaposition des trames 55 et 56 imprimées sur le produit 300. L'ajustage mécanique des modules d'impression pour aligner leurs trames respectives est complexe.

L'invention permet de résoudre ce problème en associant un dispositif de synchronisation, dont le schéma électronique est décrit à la figure 9, à une imprimante composée de plusieurs modules. L'écart physique Dy entre les trames 55 et 56 correspond à un certain nombre Q d'impulsions du signal N_{g} de fréquence donnée par un tachymètre 26 en liaison mécanique avec le produit 300, qui est l'image du déplacement en translation que devrait effectuer la partie du produit 300 placée sous le module 51, afin d'aligner les deux trames 55 et 56. Ce nombre Q n'étant pas toujours un entier, le dispositif de synchronisation comprend un multiplicateur 40 destiné à multiplier la fréquence du signal N_{g}, donc ce nombre par un nombre rationnel R pour obtenir un signal Fₜ de fréquence R fois plus grande, qui est envoyé à l'entrée du circuit de commande 512 des jets d'encre. Et cela afin que la distance séparant deux impulsions du signal Fₜ soit inférieure à l'inverse de la résolution d'impression souhaitée. Si en fonction de la densité d'impression désirée, chaque module d'impression projette un train de gouttes toutes les P impulsions, le signal Fₜ est envoyé dans un compteur 67 divisant le nombre d'impulsions du signal Fₜ par un nombre entier P, délivrant alors un signal générique de déclenchement de trame Hₜ. Ce signal Hₜ débloque simultanément deux compteurs 58 et 59 affectés respectivement aux modules d'impression 52 et 51, et qui décomptent les impulsions du signal Ft à partir d'une valeur V₅₂ chargée dans le compteur 58 et d'une valeur V₅₁ chargée dans le compteur 59. Chacun de ces deux compteurs 58 et 59 est un compteur préchargeable qui recharge automatiquement sa valeur V₅₂, respectivement V₅₁, à chaque passage à zéro. A l'initialisation de l'imprimante, un microprocesseur 60 charge les valeurs V₅₁ et V₅₂ respectivement dans les compteurs 59 et 58 à partir d'une valeur I contenue dans une mémoire 61. Dans le cas particulier de la figure 10 où le module 51 imprime avant le module 52 pour compenser l'erreur Dx, donc aligner les gouttes émises par les deux modules avec une résolution supérieure à la tolérance d'alignement mécanique des modules, la valeur V₅₁ est par exemple égale à 1 pour permettre le passage à zéro du compteur 59 et la valeur V₅₂ est égale à I+1. Ainsi le compteur 58 génère le signal d'interruption Hₜ₂ sur passage à zéro, I impulsions du signal Fₜ après le signal Hₜ₁ de passage à zéro du compteur 59. Les signaux Hₜ₁ et Hₜ₂ déclenchent respectivement l'émission des trames des modules 51 et 52.

L'invention ne se limite pas à l'exemple de réalisation décrit ci-dessus et peut aussi s'appliquer à une imprimante à jet continu dévié, composée de deux modules d'impression en mode trame qui sont accolés parallèlement au sens de défilement du produit à imprimer. Il est alors possible de superposer rigoureusement les gouttes de la trame sur celles de la trame en utilisant un dispositif de synchronisation tel que celui décrit précédemment. C'est une application particulièrement intéressante pour augmenter le pouvoir de recouvrement de certaines encres ,comme celles à pigments sur des supports sombres, par le dépôt de couches successives améliorant ainsi le contraste de marquage.

## Revendications

1. Dispositif de synchronisation du fonctionnement d'une machine (1) au déplacement du produit (2) sur lequel elle intervient, comprenant un dispositif (5) générateur d'un signal impulsionnel (N_{g}) représentatif du déplacement du produit, associé à un détecteur (7) de reconnaissance du produit, ledit générateur (5) et ledit détecteur (7) étant connectés à un circuit de commande (57) du fonctionnement de la machine, caractérisé en ce qu'il comprend de plus un multiplicateur de fréquence (9) par un nombre rationnel, placé entre le générateur (5) et le circuit de commande (57) de la machine (1), multipliant la fréquence du signal (Ng) issu du générateur dans un rapport de multiplication déterminé en fonction des variations temporelles de vitesse de déplacement du produit (2) et du nombre d'impulsions du signal issu du générateur.

2. Dispositif de synchronisation selon la revendication 1, caractérisé en ce que le multiplicateur de fréquence (9) d'un signal périodique par un nombre rationnel comprend:
- un premier convertisseur fréquence-tension (11) recevant en entrée le signal périodique (S₁) de fréquence F et délivrant une tension V qui est une fonction linéaire de la fréquence F;
- un amplificateur d'erreur (12) relié à la sortie dudit convertisseur (11) et délivrant une tension V';
- un oscillateur contrôlé en tension (13) relié à la sortie dudit amplificateur (12) et délivrant un signal (S₂) dont la fréquence est proportionnelle à la tension V' issue de l'amplificateur (12);
- un circuit diviseur (16) par un nombre entier N connecté à la sortie dudit oscillateur (13) et délivrant un signal (S₃) de même fréquence que le signal (S₁);
- un second convertisseur tension-fréquence (17) relié à la sortie du diviseur (16) et délivrant une tension Vₛ envoyée sur la seconde entrée de l'amplificateur (12);
- un circuit diviseur de fréquence (14) par un nombre entier M délivrant après amplification un signal de sortie (S₄) du multiplicateur de fréquence Fₛ égale à la fréquence F du signal d'entrée (S₁) multiplié par le nombre rationnel N/M: Fₛ=F*(N/M).

3. Dispositif de synchronisation selon la revendication 2, caractérisé en ce que les circuits diviseurs de fréquence (14) par M et (16) par N du multiplicateur de fréquence sont des compteurs.

4. Dispositif de synchronisation selon la revendication 1, caractérisé en ce que le dispositif générateur (5) d'un signal représentatif du déplacement du produit (2) est un générateur d'impulsions en contact avec le produit par l'intermédiaire d'un dispositif mécanique (6).

5. Dispositif de synchronisation selon la revendication 1, caractérisé en ce que le dispositif générateur (5) d'un signal représentatif du déplacement du produit est un photodétecteur (8).

6. Dispositif de synchronisation selon la revendication 1, caractérisé en ce que le détecteur (7) de reconnaissance du produit est une cellule photoélectrique.

7. Imprimante à jet d'encre continu dévié, constituée d'au moins deux têtes d'impression (18,19) accolées, placées parallèlement à la direction et dans le sens de déplacement du produit (2) à imprimer, chaque tête (18,19) écrivant une succession de repères (21,23) respectivement, régulièrement espacés à fréquence fixe, corrélativement à l'impression du motif, caractérisée en ce que chaque tête d'impression est synchronisée sur le déplacement du produit (2) à l'aide d'un dispositif de synchronisation selon les revendications 1 à 6,
- le dispositif de synchronisation de la première tête d'impression (18) comprenant un générateur d'impulsions (26) relié à un multiplicateur de fréquence (25) envoyant un signal de déclenchement au circuit de commande (180) des jets de ladite tête (18) et,
- le dispositif de synchronisation de la seconde tête d'impression (19) comprenant un photodétecteur (22), détectant les repères (21) émis par la première tête (18) sur le produit (2) et relié à un multiplicateur de fréquence (9) et au circuit de commande (190) des jets de ladite seconde tête (19).

8. Imprimante à jet d'encre selon la revendication 7, caractérisée en ce que le dispositif électronique (190) de commande des jets de la tête (19) comprend notamment un système de traitement électronique (28), constitué par un circuit logique de déclenchement (35), recevant d'une part le signal S1 issu du photodétecteur (22) et d'autre part le signal S₄ fourni par le multiplicateur (9) et générant un signal S₅ qui charge sur interruption une valeur V1, inscrite dans une mémoire (30), dans un compteur (34) élaborant un signal Z₃₄ de déclenchement de l'émission du premier train de gouttes et un second compteur (32), chargé sur interruption par une valeur V₂, inscrite dans une mémoire (31), et délivrant un signal Z₃₂ de déclenchement des trains de gouttes suivants liés à une même impulsion du signal S₁.

9. Imprimante à jet d'encre continu dévié constituée d'au moins deux modules d'impression (51 et 52) accolés perpendiculairement à la direction de déplacement du produit (300) à imprimer et imprimant respectivement deux trames d'encre (53 et 54), caractérisée en ce que chaque module est synchronisé sur le fonctionnement de l'autre module à l'aide d'un dispositif de synchronisation selon les revendications 1 à 6, comprenant un dispositif (26) délivrant un signal (N_{g}) représentatif du déplacement du produit (2) à imprimer, relié à un multiplicateur de fréquence (40), lui-même connecté au circuit de commande (512) des jets des deux modules.

10. Imprimante à jet d'encre selon la revendication 9, caractérisée en ce que le circuit de commande (512) des jets d'encre comprend un compteur (67) délivrant un signal de déclenchement (Hₜ) débloquant simultanément deux compteurs (58 et 59) reliés respectivement aux modules de projection (52 et 51) et délivrant les signaux Hₜ₁ et Hₜ₂ de déclenchement des trames (53 et 54) des modules (51 et 52).
